# EUROPEAN PATENT SPECIFICATION

(11) **EP 1 435 004 B1**
(45) Date of publication and mention of the grant of the patent: **13.09.2006**
(21) Application number: 02730604.2
(22) Date of filing: 21.05.2002
(51) Int. Cl.: G01R 31/316

(54) **TEST CIRCUIT**
TESTSCHALTUNG
CIRCUIT DE TEST

(30) Priority: 23.05.2001 EP 01201973
(43) Date of publication of application: 07.07.2004
(73) Proprietor: Koninklijke Philips Electronics N.V., 5621 BA Eindhoven (NL)
(72) Inventor: DE JONG, Franciscus, G., M., NL-5656 AA Eindhoven (NL); SCHUTTERT, Rodger, F., NL-5656 AA Eindhoven (NL); DE WILDE, Johannes, NL-5656 AA Eindhoven (NL); DEN BESTEN, Gerrit, W., NL-5656 AA Eindhoven (NL)
(74) Representative: Duijvestijn, Adrianus Johannes
(86) International application number: PCT/IB2002/001817
(87) International publication number: WO 2002/095430

(56) References cited:
- EP-A- 0 306 656
- EP-A- 0 747 930
- WO-A-01/63310

## Description

The invention relates to an integrated circuit and to testing of the operationality of multiple power supply connections to such an integrated circuit.

Modern integrated circuits often have a considerable number of external power supply pins for the same power supply voltage. This plurality of power supply pins poses a problem during circuit test, because malfunctioning of a part of the power supply pins does not normally show up in tests of circuit functionality.

From US patent No. 5,068,604 it is known to test the operationality of multiple power supply connections for the same supply voltage of an integrated circuit by observing the voltage drops along power supply conductors. For this purpose, a current drawing circuit is activated that draws a substantial current from the power supply to create an observable voltage drops.

Thus, the power supply connections can be tested both inside the integrated circuit and outside the integrated circuit, for example on a printed circuit board on which the integrated circuit is mounted.

In a further step, known from PCT application No. WO-A-01/63310, by inventors of the present application, it is known to provide a power supply conductor in the integrated circuit that is connected at different locations to different external power supply pins. A number of current drawing circuits is provided in the integrated circuit connected to the power supply conductor, each generally connected near a respective one of the locations where an external power supply pin is connected to the power supply conductor. It is pointed out that this PCT application has been published after the priority date of the present application and is therefore only relevant to the assessment of the novelty of the present application.

By providing different current drawing circuits at different locations it can be ensured that a supply current that balances the drawn current is supplied to the power supply conductor mainly by a power supply connection from a supply pin under test. If only a single current drawing circuit were provided, connected at a single location to the power supply conductor, supply current would mainly flow from power supply pins that are connected to the power supply conductor near that location, making it hard to detect currents from other power supply pins.

Generally, too many current drawing circuits should not be activated all at the same time. Each current drawing circuit draws a considerable current to create an observable voltage drop. Activating all or too many current drawing circuits at the same time could damage the integrated circuit due to the large resulting currents and/or power dissipation. Supply pins should be tested only one or a few at a time, activating only a few current drawing circuits that are connected to the power supply conductor near the location where the pin or pins under test is or are connected to that power supply conductor.

The operation of the known test circuit is controlled by commands entered through a boundary scan interface. The commands control the activation of the current drawing circuits, and they should ensure that not too many current drawing circuits are activated at the same time. However, if the control interface does not operate properly, for example due to the very faults in the power supply connection, or because of errors in the commands, too many current drawing circuits might be activated simultaneously, causing damage to the integrated circuit.

Amongst others, it is an object of the invention to protect the integrated circuit against damage from activation of too many current drawing circuits at the same time.

The invention provides for an integrated circuit that comprises
- a power supply conductor;
- switchable test current drawing circuits coupled to the power supply conductor at respective locations;
- a test circuit, arranged to activate alternately successive different subsets of one or more of the test current drawing circuits, and to test for currents flowing during the activation, the test circuit comprising a signal line specific to a first one of the subsets, for carrying a signal indicative of completion of activation of the first one of the subsets, and wherein activation of a second one of the successive subsets is controlled by the signal on the signal line.

Thus it is ensured a first and second subset of current drawing circuits cannot be activated simultaneously, even if there are errors, by using separate signal lines for different subsets of the current drawing circuits and ensuring that a next subset can only be activated when the signal line of the preceding subset indicates that that preceding subset has been de-activated.

In an embodiment of the integrated circuit according to the invention the test circuit is triggered by a reset of the circuit (for example a power-on reset or another type of reset). Thus, the test of the power supply connections can be performed before any other test, even without loading a scan chain. Power supply faults, which might lead to erroneous results in other tests can thus be detected before these other tests are performed.

In another embodiment of the integrated circuit according to the invention, activation of a subset of the current drawing circuits is triggered by an indication that a test using a previous subset of current drawing circuits has detected no failure. Thus, no additional signal lines are needed to sequence the activation of different subsets of the current drawing circuits. If one of the tests indicates a failure, no further tests are performed, additionally reducing the risk of damage.

These and other objects and advantages of the circuits and methods according to the invention will be described in more detail using the following drawing.
Figure 1 shows a circuit;
Figure 2 shows a further circuit.

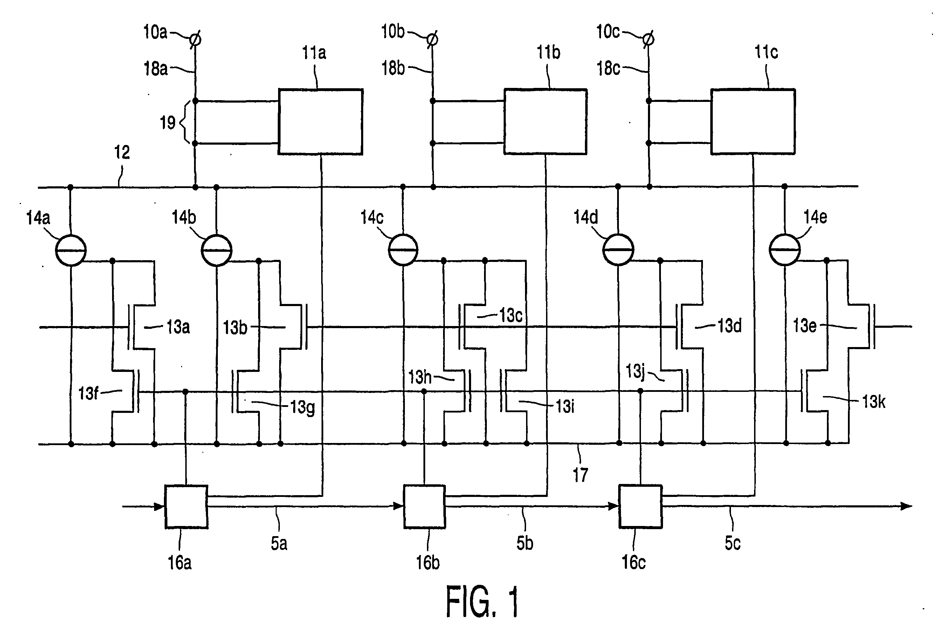

Figure 1 shows part of an integrated circuit. The integrated circuit contains power supply pins 10a-c of the integrated circuit and a power supply conductor 12 connected via respective power supply connections 18a-c. The integrated circuit also contains voltage drop measuring circuits 11a-c, control switches 13a-k current sources 14a-e control circuits 16a-c and a further power supply conductor 17. The power supply conductor 12 is coupled to the further power supply conductor 17 via a number of current sources 14a-e. The control switches 13a-h are controlled by control circuits 16a-c. The voltage drop measuring circuits 11a-c are each coupled at two points to a respective one of the power supply connections 18a-c. The control circuits 16a-c are coupled in a chain, each control circuit in the chain having an output coupled to a next control circuit 16a-c in the chain.

The power supply conductor 12 normally serves to distribute supply power supply current to normal operating circuits (not shown) such as memories, processor cores etc. in the integrated circuit. When the integrated circuit is mounted on a carrier, such as a printed circuit board (not shown), the supply pins 10a-c are electrically connected to one or more supply lines (not shown) on the printed circuit boards. Current is supplied to the power supply conductor 12 from the printed circuit board via the supply pins 10a-c.

The components shown in figure 1 serve to test whether current is supplied normally from each of the power supply pins 10a-c.

In operation, current from each power supply pin 10a-c is detected successively. To test the current from a supply pin 10a-c, a control circuit 16a-c activates (make conductive) a subset of the current sources 14a-e, so that only this subset of the current sources 14a-e draws current from the power supply conductor 12.

The first control circuit 16a for example makes a first, second and third current source 14a-c draw current from the power supply conductor 12. The second current source 14b draws current mainly from the first power supply connection 18a. The first and third current source prevent that this current is significantly reduced due to currents from other power supply connections. When first control circuit 16a has activated the first, second an third current source 14a-c, first control circuit 16a reads a current detection result from the first voltage drop measuring circuit 11a.

The first voltage drop measuring circuit 11a compares the voltage drop over a part 19 of the power supply connection 18a with a threshold and outputs a result of this comparison to first control circuit 16a. This voltage drop is a consequence of the (small) parasitic resistance of the part 19 and the supply current through the connection 18a (if any). Once the result of the comparison has been obtained, first control circuit 16a deactivates the first, second an third current source 14a-c.

The first control circuit 16a signals on its output to second control circuit 16b via signals line 5a that the current sources 14a-c have been deactivated. In response, the second control circuit starts its part of the test, activating the second, third and fourth current source 14b-d and measuring the current through the second power supply connection 18b. At the end of this measurement the second control circuit 16b deactivates the current sources 14b-d and signals completion to the next control circuit 16c via its signal line 5b and so on (via signal line 5c and further signal lines. Thus the control circuits 16a-c are active one after the other, each activating a subset of the current sources 14a-e. At no time all of the current sources 14a-e are active simultaneously.

In one embodiment, the control circuits operate under control of a clock (not shown), taking over control signals to start testing from preceding circuits on clock edges. In another embodiment, the control circuits are asynchronous, starting testing upon a transition in a signal from a preceding control circuit.

Although figure 1 shows a particular embodiment it will be clear that different embodiments are possible without deviating from the invention. For example, in general a much larger number of power supply connections 18a-c and current sources 14a-e will be connected to the power supply conductor 12. Also, the number of current sources that is activated may vary. For example, in some cases a control circuit may activate only a single current source and in other cases the control circuit may activate more than three current source. This depends on the extent to which it is necessary to screen the effect of different power supply connections, which in turn depends on the required accuracy and the topography of the integrated circuit. Instead of current sources 14a-e other current drawing elements may be used etc.

Figure 1 shows the control circuits 16a-c activating each other in a single chain. However, without deviating from the invention the control circuits may activate each other in more complicated sequences.

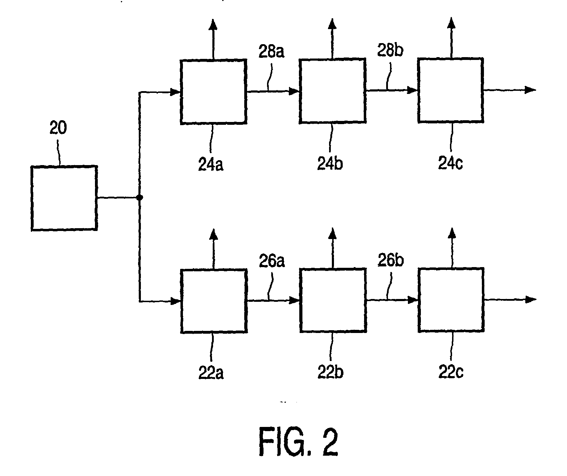

Figure 2 shows connections between control circuits 20, 22a-c and 24a-c. In this arrangement, the control circuits in a first chain 22a-c activate each other in turn and control circuit in a second branch 24a-c activate each other in turn via signal lines 26a-b, 28a,b respectively. Such a structure may be used for example when the current drawing circuits controlled by the control circuits 22a-c in the first chain are at a substantial distance in the integrated circuit from the current drawing circuits controlled by the control circuits 24a-c in the second chain. Thus, the test is speeded up.

Various types of signal lines 5a-c, 26a-b, 28a-b may be used to pass control signals from one control circuit 16a-c, 20, 22a-c, 24a-c to another. In one embodiment, a "ready" signal output is used for this, which is asserted when the test has been completed. In this embodiment the tests are preferably executed for all power supply connections and the results of these tests are read out through a shift register, or "anded" to form a single fail/no fail result indicating whether any or none of the power supply connection has failed.

In an advantageous embodiment a test result output of the control circuit is used for this. In this embodiment, all control circuits are reset to a "fail" state at the start of testing. When a voltage drop measuring circuit 11a-c measures that current flows through a connection under test, the control circuit is set to the no-fail state. A signal indicating the sate of the control circuit is passed to the next control circuit to control the start of the test. Thus, a control circuit will not start a test if any of its predecessors has detected a failure. At the end of the chain (or chains) of control circuits only the output of the final control circuit needs to be read out to determine whether the integrated circuit has no power supply failures.

The start of the test may be controlled by a command from a scan chain (not shown). But in a preferred embodiment, the test is started by a signal at a reset input (not shown) of the integrated circuit, or by a circuit which detect power up and signals this to a reset input. Such a reset input is also coupled to various functional elements (not shown) in the integrated circuit and has a function in normal (non-test) operation of the integration circuit to set these functional element to a suitable initial state for starting normal operation. By using the reset input to triggered the power supply test (preferably conditional on a test enable signal to the integrated circuit being asserted during the reset) it is ensured that the power supply test is executed at the start of operation of the integrated circuit, starting before any other tests.

This has the advantage of eliminating the influence of any errors on the start of the test and of making it possible to stop further testing at the start of testing if there is a power supply failure, which might compromise further tests. It will be clear that this advantage also holds when no special measures (such as signal lines 5a-c) are provided to prevent simultaneous activation of the current drawing circuits 14a-e. But the use of such signal lines is especially advantageous in the case of power supply test on reset, because in that case the tests circuit cannot be independently tested before switching on the current drawing circuits to detect the risk of damage due to errors.

## Claims

1. An integrated circuit that comprises
- a power supply conductor (12) fed by power supply connections (18a-c);
- switchable test current drawing circuits (14a-e) coupled to the power supply conductor (12) at respective locations; and
- a test circuit (16a-c, 11a-c, 22a-c, 24a-c), arranged to activate alternately successive different subsets of one or more of the test current drawing circuits (14a-e), and to test for currents flowing to the power supply conductor (12) during the activation, wherein the test circuit (16a-c, 11a-c) comprises a signal line (5a-c, 26a-c, 28a-b) specific to a first one of the subsets for carrying a signal indicative of completion of activation of the first one of the subsets, and wherein activation of a second one of the successive subsets is controlled by the signal on the signal line.

2. An integrated circuit according to Claim 1, wherein the signal is furthermore indicative of a non-failure result of a test using the first one of the subsets.

3. An integrated circuit according to Claim 1, comprising respective signal lines (5a-c, 26a-c, 28a-b) specific to respective ones of the subsets in a chain of the subsets, each for carrying a signal indicative of completion of activation of the respective one of the subsets, and wherein activation of each successive subset in the chain is controlled by the signal on the signal line (5a-c, 26a-c, 28a-b) for a preceding one of the subsets in said chain.

4. An integrated circuit according to Claim 3, wherein each of the signals is furthermore indicative of a non-failure result of a test using its specific subset.

5. An integrated circuit according to Claim 1, comprising an overall reset input for resetting functional circuits of the integrated circuit, the test circuit being arranged to start alternately activating the different subsets in response to the reset signal.

6. An integrated circuit according to (Claim 1, wherein the signal on said signal line (5a-c, 26a-c, 28a-b) is a signal indicative of failure or no-failure result of the test during activation of the corresponding subset, the test circuit being arranged to indicate a failure on said signal line at least until the test during activation of the corresponding subset is executed, the at least one of the successive subsets being activated only if a no-failure result is indicated for the test during activation of the preceding subset.

7. Method of testing power supply connections (18a-c) to an integrated circuit, the method comprising
- testing for currents flowing during the activation of different subsets of one or more of test current drawing circuits (14a-e) drawing current from a power supply conductor (12) in the integrated circuit;
- generating, on a signal line (5a-c, 26a-c, 28a-b) specific for a first one of the subsets, a respective signal indicative of completion of activation of the first one of the subsets; and
- activating alternately successive ones of the different subsets, activation of a second one of the subsets being controlled by the signal indicative of completion of activation of the first one of the subsets.

8. A method according to claim 7, wherein the respective signal is furthermore indicative of a non-failure result of a test using the first one of the subsets.

## Patentansprüche

1. Integrierte Schaltung, die Folgendes umfasst:
- einen von Stromversorgungsverbindungen (18a-c) gespeisten Stromversorgungsleiter (12);
- schaltbare, Teststrom ziehende Schaltungen (14a-c), die an entsprechenden Positionen an den Stromversorgungsleiter (12) gekoppelt sind; und
- eine Testschaltung (16a-c, 11a-c, 22a-c, 24a-c), die ausgebildet ist, abwechselnd aufeinander folgende unterschiedliche Teilmengen von einer oder mehreren der Teststrom ziehenden Schaltungen (14a-e) zu aktivieren und auf Ströme, die während der Aktivierung zu dem Stromversorgungsleiter (12) fließen, zu testen, in der die Testschaltung (16a-c, 11a-c) eine Signalleitung (5a-c, 26a-c, 28a-b) umfasst, die spezifisch für eine erste der Teilmengen ist, um ein Signal zu transportieren, das auf die Vollendung der Aktivierung der ersten der Teilmengen hinweist, und in der die Aktivierung einer zweiten der aufeinander folgenden Teilmengen durch das Signal auf der Signalleitung gesteuert wird.

2. Integrierte Schaltung nach Anspruch 1, in der das Signal außerdem auf ein Null-Fehler-Ergebnis eines Tests, der die erste der Teilmengen verwendet, hinweist.

3. Integrierte Schaltung nach Anspruch 1, die entsprechende Signalleitungen (5a-c, 26a-c, 28a-b) umfasst, die spezifisch für entsprechende der Teilmengen in einer Kette der Teilmengen sind, jede um ein Signal zu transportieren, das auf die Vollendung der Aktivierung der entsprechenden der Teilmengen hinweist, und in der die Aktivierung jeder aufeinander folgenden Teilmenge in der Kette durch das Signal auf der Signalleitung (5a-c, 26a-c, 28a-b) für eine vorangegangene der Teilmengen in der genannten Kette gesteuert wird.

4. Integrierte Schaltung nach Anspruch 3, in der jedes der Signale außerdem auf ein Null-Fehler-Ergebnis eines Tests hinweist, der seine spezifische Teilmenge verwendet.

5. Integrierte Schaltung nach Anspruch 1, die einen Gesamtrücksetzeingang zum Rücksetzen von Funktionsschaltungen der integrierten Schaltung umfasst, wobei die Testschaltung ausgebildet ist, abwechselnd die verschiedenen Teilmengen als Antwort auf das Rücksetzsignal zu starten.

6. Integrierte Schaltung nach Anspruch 1, in der das Signal auf der genannten Signalleitung (5a-c, 26a-c, 28a-b) ein Signal ist, das auf ein Fehler- oder Null-Fehler-Ergebnis des Tests während der Aktivierung der entsprechenden Teilmenge hinweist, wobei die Testschaltung ausgebildet ist, einen Fehler auf der genannten Signalleitung anzuzeigen, mindestens bis der Test während der Aktivierung der entsprechenden Teilmenge ausgeführt ist, wobei die mindestens eine der aufeinanderfolgenden Teilmengen nur aktiviert wird, wenn für den Test während der Aktivierung der vorhergehenden Teilmenge ein Null-Fehler-Ergebnis angezeigt wird.

7. Verfahren zum Testen von Stromversorgungsverbindungen (18a-c) zu einer integrierten Schaltung, wobei das Verfahren Folgendes umfasst:
- Testen auf Ströme während der Aktivierung verschiedener Teilmengen einer oder mehrerer Teststrom ziehender Schaltungen (14a-e), die Strom aus einem Stromversorgungsleiter (12) in der integrierten Schaltung ziehen;
- Erzeugen eines entsprechenden Signals auf einer, für eine erste der Teilmengen spezifischen Signalleitung (5a-c, 26a-c, 28a-b), das auf die Vollendung der Aktivierung der ersten der Teilmengen hinweist; und
- abwechselndes Aktivieren von aufeinanderfolgenden der verschiedenen Teilmengen, wobei Aktivieren einer zweiten der Teilmengen von dem Signal gesteuert wird, das auf die Vollendung der Aktivierung der ersten der Teilmengen hinweist.

8. Verfahren nach Anspruch 7, in dem das entsprechende Signal außerdem auf ein Null-Fehler-Ergebnis eines Tests hinweist, der die erste der Teilmengen verwendet.

## Revendications

1. Circuit intégré qui comprend
- un conducteur d'alimentation en énergie (12) qui est alimenté par des connexions d'alimentation en énergie (18a à c);
- des circuits de prélèvement de courant d'essai commutables (14a à e) qui sont couplés au conducteur d'alimentation en énergie (12) à des emplacements respectifs; et
- un circuit d'essai (16a à c, 11a à c, 22a à c, 24a à c) qui est agencé de manière à activer alternativement des sous-ensembles différents successifs d'un ou de plusieurs circuits de prélèvement de courant d'essai (14a à e) et de manière à essayer des courants circulant vers le conducteur d'alimentation en énergie (12) pendant l'activation, dans lequel le circuit d'essai (16a à c, 11a à c) comprend une ligne de signal (5a à c, 26a à c, 28a à b) qui est spécifique d'un premier des sous-ensembles pour véhiculer un signal étant indicatif de l'achèvement de l'activation du premier des sous-ensembles et dans lequel l'activation d'un deuxième des sous-ensembles successifs est commandée par le signal sur la ligne de signal.

2. Circuit intégré selon la revendication 1, dans lequel le signal est de plus indicatif d'un résultat sans défaillance d'un essai utilisant le premier des sous-ensembles.

3. Circuit intégré selon la revendication 1, comprenant des lignes de signal respectives (5a à c, 26a à c, 28a à b) qui sont spécifiques des sous-ensembles respectifs des sous-ensembles dans une chaîne des sous-ensembles, chacune pour véhiculer un signal qui est indicatif de l'achèvement de l'activation du sous-ensemble respectif des sous-ensembles, et dans lequel l'activation de chaque sous-ensemble respectif dans la chaîne est commandée par le signal sur la ligne de signal (5a à c, 26a à c, 28a à b) pour un sous-ensemble précédent des sous-ensembles dans ladite chaîne.

4. Circuit intégré selon la revendication 3, dans lequel chacun des signaux est en plus indicatif d'un résultat sans défaillance d'un essai utilisant son sous-ensemble spécifique.

5. Circuit intégré selon la revendication 1, comprenant une entrée de remise à zéro totale pour remettre à zéro des circuits fonctionnels du circuit intégré, le circuit d'essai étant agencé de manière à commencer alternativement l'activation des sous-ensembles différents en réaction au signal de remise à zéro.

6. Circuit intégré selon la revendication 1, dans lequel le signal sur ladite ligne de signal (5a à c, 26a à c, 28a à b) est un signal qui est indicatif du résultat de défaillance ou du résultat sans défaillance de l'essai pendant l'activation du sous-ensemble correspondant, le circuit d'essai étant agencé de manière à indiquer une défaillance sur ladite ligne de signal au moins jusqu'à ce que l'essai pendant l'activation du sous-ensemble correspondant soit exécuté, le au moins un des sous-ensembles successifs étant activé seulement si un résultat sans défaillance est indiqué pour l'essai pendant l'activation du sous-ensemble précédent.

7. Procédé de mise à l'essai de connexions d'alimentation en énergie (18a à c) à un circuit intégré, le procédé comprenant
- la mise à l'essai de courants circulant pendant l'activation de sous-ensembles différents d'un ou de plusieurs circuits de prélèvement de courant d'essai (14a à e) qui prélèvent du courant sur un conducteur d'alimentation en énergie (12) dans le circuit intégré;
- la génération, sur une ligne de signal (5a à c, 26a à c, 28a à b) qui est spécifique d'un premier des sous-ensembles, d'un signal respectif étant indicatif de l'achèvement de l'activation du premier des sous-ensembles; et
- l'activation alternative de sous-ensembles successifs des sous-ensembles différents, l'activation d'un deuxième des sous-ensembles étant commandé par le signal qui est indicatif de l'achèvement de l'activation du premier des sous-ensembles.

8. Procédé selon la revendication 7, dans lequel le signal respectif est de plus indicatif d'un résultat sans défaillance d'un essai utilisant le premier des sous-ensembles.
